# EUROPEAN PATENT APPLICATION

(11) **EP 3 104 239 A1**
(43) Date of publication of application: **14.12.2016**
(21) Application number: 15001688.9
(22) Date of filing: 08.06.2015
(51) Int. Cl.: G05B 19/418, G05B 23/02

(54) **METHOD FOR MOBILE ON-SITE BUILDING ENGINEERING USING IN COMMODITY DEVICES**

(71) Applicant: ABB AG, 68309 Mannheim (DE)
(72) Inventor: Gamer, Thomas, 68782 Brühl (DE); Vorst, Philipp, 68259 Mannheim (DE)

(57) **Abstract**

The invention relates to a method and a device for mobile on-site building engineering comprising the steps of using at least a camera of the mobile device to identify and to locate one or more automation devices in a room of a building, wherein automation devices are electrical or electronic devices; obtaining identification information about the automation devices; establishing functional relationships between one of the automation devices and another one of the automation devices and/or assigning functions to one or more identified automation devices.

## Description

### Technical field

The present invention relates to methods and devices with e.g. WLAN, 4G or Bluetooth capability, for supporting engineering processes related to electrical or electronic devices and their functional connections in buildings.

### Related art

In order to engineering a building, i.e., configuring class and type for electrical or electronic automation or installation devices, such as wall switches, light installations on walls or ceilings, control devices for heating or cooling purposes, control devices for locking and unlocking purposes, or alarm systems and subsequently mapping functionality to devices or connect them in order to achieve a specific functionality, PC-based engineering tools are often used. With such engineering tools, data items/nodes are typically created manually based on a building specification or a building plan.

Functional or template-based engineering tools already exist with simplify such configuration and engineering. Finally, commissioning is done by uploading configurations to devices.

From document US 2006/0119767A1 a method of configuring automation devices in a building automation system is known comprising acquiring an electronic layout for the building automation system, populating the electronic layout with a plurality of automation devices, and establishing relationships among the automation devices in the electronic layout.

In document WO 2013063495 A1 a method for commissioning a node is disclosed using a network of communicatively-connected components, the method comprising obtaining ranging measurements from a first node and a second node indicating respective distances to a third node each using a respective wireless interface to obtain the ranging measurements, determining a location of the third node based, at least in part, on the ranging measurements; and automatically commissioning the third node by associating the third node with one or more components of the network based, at least in part, on the determined location of the third node.

In document WO 2014/167465 A1 a control device for controlling the environment in a region within a structure by means of controlling operation of a control system adapted to adjust at least one property of the environment in the region is disclosed. The control device comprises a user interface adapted to selectively indicate to a user a range of available values representing at least one property of the environment in the region that is adjustable by the control system; and to enable the user to control the represented property, whereby the control device is provided with user input. It further comprises a communication unit adapted to adjust the at least one property by means of communicating a control signal corresponding to said user input to the control system, wherein the user interface is adapted to selectively indicate to the user a range of available values representing at least one property of the environment in the region that is adjustable by the control system based on presence information of any persons being present within the region such that the extent of control of the environment in the region by means of the control device.

It is an object of the present invention to provide a method for mobiie on-site building engineering and a mobile device therefor, which support a user at engineering processes related to electrical or electronic automation devices and their functional assignments and interconnections in buildings in an improved manner.

### Summary of the invention

The above object has been achieved by the method for mobile on-site building engineering according to claim 1 as well as by the mobile device and by the system according to the further independent claims.

Further embodiments are indicated in the dependent claims.

According to a first aspect, a method for mobile on-site building engineering is provided comprising the steps of:
- using at least a camera of the mobile device to identify and to locate one or more automation devices in a room of a building, wherein automation devices are electrical or electronic devices;
- obtaining identification information about the automation devices;
- establishing functional relationships between one of the automation devices and another one of the automation devices and/or assigning functions to one or more identified automation devices.

There are various approaches for commissioning and connecting electrical and electronic automation devices in buildings, such as wall switches, light installations on walls or ceilings, control devices for heating or cooling purposes, control devices for locking and unlocking purposes, alarm systems or the like. However, in contrast to conventional approaches the above method allows the use of a mobile device, such as a portable phone or a portable tablet, and its sensing capabilities such as the camera and particularly other mobile device sensors to identify and to locate the automation devices installed or to be installed in a room of the building so that on-site identification information (context information) of the automation devices can be retrieved and recorded. Thereby, it could create additional benefits in buildings, such as residential and commercial buildings, for maintenance of existing installations of automation devices, during commissioning of the automation devices and for service procedures related to the automation devices. Thus, the above method helps to simplify the engineering of automation in buildings by using a mobile device and its camera on-site instead of relying on a remote PC-based working place.

The simplification of the above process is achieved by using the camera of the mobile device to subsequently "point" to the automation devices and to quickly manually or automatically configure the automation devices, e.g., through an augmented reality application, as well as the functional mapping, e.g., of switch and lighting unit, e.g. by a drag-and-drop operation. The method also includes the identification of automation devices, e.g., by allocating to a building plan available in the mobile device or remote therefrom or by associating with a device list in the mobile device or provided remote therefrom.

The above method using a mobile device allows engineering building automation systems while being on-site, i.e. in the building, instead of working on a PC at a remote location. This allows a more general view on the needs of specific places in the building. Furthermore, engineering by being on site and using camera for configuration/commissioning is more effective.

Another aspect of the inventive method allows to service building automation systems, such as re-engineering during extensions or renovations.

Furthermore, the identification information can include information of one of a device type, a device class, a device function, a device address, a device identifier or an advanced functionality:
It is provided that the identification information is obtained one of:
   - by manually selecting the location description from an existing building plan,
   - by manually selecting a provided device identification code from an existing inventory list,
   - by manually specifying the location in the building inventory or building plan,
   - by automatically performing an image recognition of the image obtained by the camera and by manually querying in a database depending on a recognized automation device to assign identification information,
   - by associating an interpreted voice information of the user to the automation device identified by the camera;
   - by prompting a user to select from the pre-configured application menu the automation device class and to specify the device type;
   - by selecting from locations of all automation devices shown in a building floor plan, wherein to automation devices shown in a building floor plan identification information is assigned; and/or
   - by receiving from the automation device to be identified, particularly by means of a QR tag, via NFC, Bluetooth, or WLAN/4G.

Moreover, establishing functional relationships between one of the automation devices and another one of the automation devices can be performed by a mapping between the identified automation devices by assigning on the basis of devices to devices or devices functions to device functions.

It can be provided that the mapping is performed by suitable input operations on the mobile device indicating at least two automation devices.

Particularly the mapping is performed by a finger gesture particularly by typing on one of the automation devices 4 and sliding/moving it to the respective other automation device 4

According to a further aspect, a mobile device for mobile on-site building engineering is provided comprising:
- a camera configured to acquire an image of one or more automation devices in a room of a building;
- a control unit configured to
   ∘ identify and to locate one or more automation devices, wherein automation devices are electrical or electronic devices;
   ∘ to obtain identification information about the automation devices;
   ∘ to establish functional relationships between one of the identified automation devices and another one of the identified automation devices and/or assigning functions to one or more identified automation devices.

According to an inventive aspect, the mobile device for mobile on-site building engineering is provided comprising configured to perform above functions on a remote device (e.g. a cloud) connected over a communication network.

According to a further aspect, a system including the above mobile device and one or more automation devices is provided.

Particularly each of the automation devices can comprise at least one of a wall switch, a light unit installation on a wall or on a ceiling of the room, a control device for heating or cooling purposes, a control device for locking and unlocking purposes, a locking device, and an alarm system.

### Brief description of the drawings

Embodiments are described in more detail in conjunction with the accompanying drawings, in which:
- Figure 1: shows a system with a mobile device and automation devices;
- Figure 2: shows a flowchart illustrating the steps of the method for establishing relationships among the automation devices; and
- Figure 3: an exemplary room of a home or a building and multiple exemplary display screens "illustrating the process described in conjunction with Figure 2.

### Description of embodiments

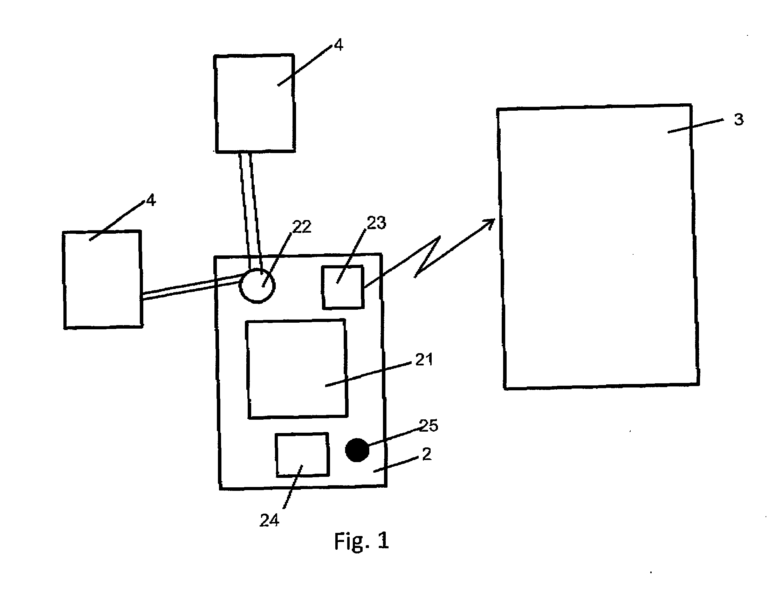

Figure 1 shows a system 1 for use in a building including a mobile device 2 such as a portable smartphone or a portable tablet, which allows mobile computing. The mobile device 2 has a display screen 21 with touch-input capabilities (touchpad), a camera 22 for acquiring images of the environment, a data communication interface 23 for communicating with a remote database 3, a control unit 24 to operate the mobile device 2, and optionally a position detector 25 for obtaining an indication about a position in the building.

In a room of the building, automation devices 4, such as a wall switch, a light unit installation on a wall or on a ceiling of the room, a control device for heating or cooling purposes, a control device for locking and unlocking purposes, an alarm system or the like, is applied, which can be recorded by the camera 22 of the mobile device 2. The recorded image of the automation device 4 allows to identify the automation device 4 by its type or its class or to associate identification information about its type. Furthermore, the recorded image of the automation device 4 allows determining its location.

The data communication interface 23 can be connected to the database wirelessly, such as by WiFi, Bluetooth or the like.

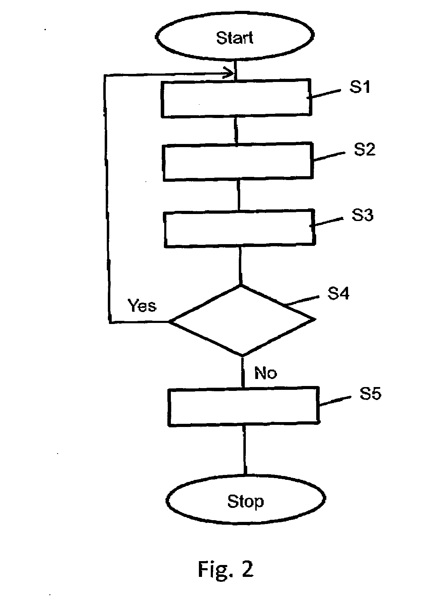

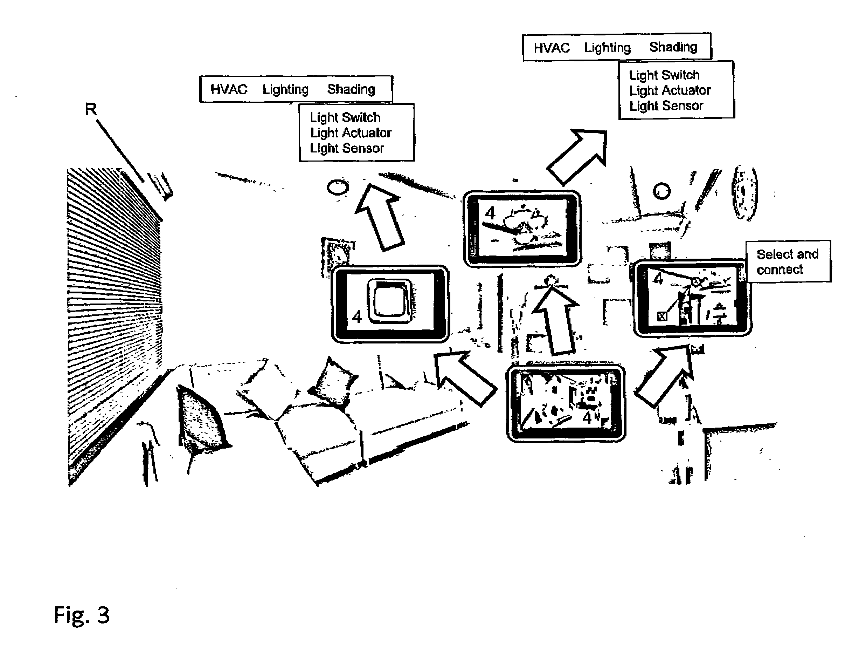

Figure 2 shows a flow chart illustrating method steps, which are executed in the control unit 24 of the mobile device 2. For example, an according engineering application is installed as software or an app. Figure 3 sketches the method steps in an exemplary environment of a room in a building.

In step S1 a picture of a first automation device 4 in a room R of a building is taken by a user carrying the mobile device 2 in order to engineer one or more automation devices 4 in this room.

In step S2 an identification of the automation device 4 is carried out. Generally, device identification information can e.g. be achieved by manually selecting the location description from an existing building plan, by manually selecting a provided device identification code from an existing inventory list, or by manually specifying the location in the building inventory or building plan. Identification of the automation device 4 means to assign identification information, which are included information of one of a device type, a device class, a device function, a device address, a device identifier or an advanced functionality:
- The identification can be automatically performed by image recognition and manually query in a respective database to assign identification information in order to identify the automation device. Furthermore, an automatic assignment can implemented by an image recognition algorithm, so that an auto-configuration of the device function (e.g., light switch) can made based on camera images.
- The device function (e.g., light switch) can be determined by imaging the automation device 4 and by associating interpreted voice information of the user to the automation device 4. By means of voice, recognition in a recorded voice of the user the automation device 4 can be assigned an identification information including indications of a device function.
- After an image of the automation device 4 has been taken, a pre-configured application menu can be displayed prompting the user to select from the pre-configured application menu the automation device class and specifies the device type, such as "lighting" and "light switch" in this example.
- Similarly, a device inventory list can be available in the mobile device 2 or in the database 3 including device information. Having selected device classes and types, the user can select the currently engineered automation device 4 from the inventory list and thus connects it to the automation device information of the inventory.
- A building floor plan showing the locations of all automation devices 4 can be made available in the mobile device 2 or in the database 3 and can be shown after the image of the respective automation device 4 has been taken. Then the currently pictured automation device 4 is selected by the user from the building plan and thus connected to provided identification and/or location information of the building plan.
- Further identification information is provided by the automation device 4 itself locally or by the mobile device 2 or the database 3. The automation device 4 could, for example, carry a QR tag or wirelessly send information by NFC, Bluetooth, WLAN/4G or the like. The mobile device 2 is configured to acquire this identification information, using either the camera (reading the QR tag) or inbuilt communication functionality (NFC, Bluetooth, Internet access by WLAN/4G, etc.). If the automation device 4 doesn't provide information on its class and type by its own, other means such as image recognition could be used to automatically detect, identify and configure automation devices 4 that are seen on-site by the camera 22 of the mobile device 2. The identification and configuration step in this case has to rely on a-priori knowledge used by image recognition.

In step S3 a position information can be assigned to the automation device 4. The position of the automation device 4 can be automatically detected by locating the mobile device 2 and its orientation so that the direction, in which the image is taken and so the position of the automation device 4 can be determined by image processing, which is generally known in the art. Furthermore, if positions of automation devices 4 are known from a building plan or a prior planning phase, the location of the automation device 4 in the building is detected by a query in a respective database.

This step can also be enhanced by adding information to an existing building plan. In this case, the user could approve the information shown in the building plan and add additional information such as a picture of the automation device 4 or indoor navigation coordinates after having identified the automation device 4 on the building plan. If a building plan is available and the mobile device 2 features a localization mechanism, the location and direction information as well as the camera information can lead to an automatic estimation of the position of the automation device 4. This position can be matched with the location as available from an existing building plan, and so an automatic allocation of the automation device 4 acquired by the camera 22 with the automation device 4 as included in the building plan can be made. In case of a high density of automation devices 4 in the actual room of the building, the user can be prompted to select one of a list of closest candidates of automation devices 4.

If no position information of automation devices 4 is available from a building plan or prior planning phase, the information has to be added manually during engineering. In such case, the location of the automation device 4 has to be specified manually after having selected device class and type. This can be done, for instance, textually, by coordinates, or graphically on an empty building plan.

In step S4 it is checked if further automation devices 4 in the room shall be identified. If "Yes" the process returns to step S1 otherwise it is continued with step S5.

In step S5 a mapping between the identified automation devices can be made by assigning device-to-device or device function-to-device function.

The mapping can be performed by suitable input operations on the mobile device 2. indicating at least two automation devices 4, which shall be functionally mapped. In an example as illustrated in Figure 3, the user points the camera 22 of the mobile device 2 toward the light switch in the room as an exemplary automation device 4 (Step 1). According to above described process the light switch is identified and located. Similarly, the user points the mobile device's camera 22 toward a ceiling lamp as another automation device 4 in the room and zooms in/out, if required. Then the other automation device 4 is identified, e.g. by selecting from a pre-configured application menu the device class and specifies the device type - "lighting" and "light actuator" (Step 2).

For mapping, the user zooms out and on the display screen the two automation devices 4 are displayed, which have been configured before. The control unit of the mobile device 2 is configured to perform the basic display functions such as showing the taken image, providing zoom-in / zoom-out functions and displaying the identified automation devices 4 marked-up using well known methods of augmented reality. There could be different marked-ups depending on device class and device type to clearly show the differences from a functional point of view. The automation devices can be mapped by finger gesture (Step 3) such as typing on one of the automation devices 4 and sliding/moving it to the respective other automation device 4 to "show" that there is a functional link between the automation devices 4. Therefore, the control unit can be configured to assign two or more identified automation devices 4 by means of the touchscreen capability of the mobile device 2, e.g. by swiping a finger from the one marked-up automation device to the other marked-up automation device 4 to connect the two automation devices and so mapping the device functionalities in order to achieve a common function. In above example, the user connects the two automation devices 4 in order to map light switch functionality to switching on/off the ceiling light.

Additionally or alternatively, the information collected on-site based on the previous steps could also be processed remotely by just transferring images and identification information taken in the building to an external engineering platform. Hence, a user does not need to do the mapping step on-site using the current camera stream but could do the mapping e.g. using a PC-based working place. Hence, the mobile device 2 can be configured to transfer the obtained identification information to an external engineering platform to be further processed by engineering experts remotely.

Instead of performing the functional mapping manually, a template-based approach could be used in order to automatically perform the mapping, if the automation devices 4 added and configured in the previous steps fit to a certain pre-configured template. For example, light switches and lighting units could be automatically matched under certain conditions, such as only one lighting unit is available, so that all light switches are functionally mapped with the one lighting unit.

Having done the assignment of identification information and the function mapping, further automatic tasks are executed, such as automatic addressing based on the knowledge that the automation devices 4 are in the same room.

As a further embodiment, the images of the automation device can be taken by a mobile robot, which is configured to move through the rooms of the building. Unless a human operator exists to process the pictures taken, the mobile robot may be configured to automatically recognize automation devices and assigned thereto device types/classes and/or locations and/or wirelessly identify visible devices.

## Claims

1. Method for mobile on-site building engineering comprising the steps of:
- using at least a camera of the mobile device to identify and to locate one or more automation devices in a room of a building, wherein automation devices are electrical or electronic devices;
- obtaining identification information about the automation devices;
- establishing functional relationships between one of the automation devices and another one of the automation devices and/or assigning functions to one or more identified automation devices.

2. Method according to claim 1, wherein the identification information includes information of one of a device type, a device class, a device function, a device address, a device identifier or an advanced functionality.

3. Method according to claim 1 or 2, wherein the identification information is obtained:
- by manually selecting the location description from an existing building plan, and/or
- by manually selecting a provided device identification code from an existing inventory list, and/or
- by manually specifying the location in the building inventory or building plan, and/or
- by automatically performing an image recognition of the image obtained by the camera and by manually querying in a database depending on a recognized automation device to assign identification information, and/or
- by associating an interpreted voice information of the user to the automation device identified by the camera; and/or
- by prompting a user to select from the pre-configured application menu the automation device class and to specify the device type; and/or
- by selecting from locations of all automation devices shown in a building floor plan, wherein to automation devices shown in a building floor plan identification information is assigned; and/or
- by receiving from the automation device to be identified, particularly by means of a QR tag, via NFC, Bluetooth, or WLAN/4G.

4. Method according to any of the claims 1 to 3, wherein establishing functional relationships between one of the automation devices and another one of the automation devices is performed by a mapping between the identified automation devices by assigning on the basis of devices to devices or devices functions to device functions.

5. Method according to claim 4, wherein the mapping is performed by suitable input operations on the mobile device indicating at least two automation devices.

6. Method according to claim 4 or 5, wherein the mapping is performed by a finger gesture particularly by typing on one of the automation devices and sliding/moving it to the respective other automation device.

7. Mobile device for mobile on-site building engineering comprising:
- a camera configured to acquire an image of one or more automation devices in a room of a building;
- a control unit configured to
∘ identify and to locate one or more automation devices, wherein automation devices are electrical or electronic devices;
∘ to obtain identification information about the automation devices;
∘ to establish functional relationships between one of the identified automation devices and another one of the identified automation devices and/or assigning functions to one or more identified automation devices or
- configured to perform the functions
∘ identify and to locate one or more automation devices, wherein automation devices are electrical or electronic devices;
∘ to obtain identification information about the automation devices;
∘ to establish functional relationships between one of the identified automation devices and another one of the identified automation devices and/or assigning functions to one or more identified automation devices,
- on a remote device (e.g. a cloud) connected over a communication network.

8. System including a mobile device according to claim 7 and one or more automation devices.

9. System according to claim 8, wherein each of the automation devices comprises at least one of a wall switch, a light unit installation on a wall of the room, a control device for heating or cooling purposes, a control device for locking and unlocking purposes, a locking device, an alarm system.
